# EUROPÄISCHE PATENTSCHRIFT

(11) **EP 2 050 131 B1**
(45) Veröffentlichungstag und Bekanntmachung des Hinweises auf die Patenterteilung: **29.07.2015**
(21) Anmeldenummer: 07788079.7
(22) Anmeldetag: 31.07.2007
(51) Int. Cl.: H05K 3/14, H01L 23/48

(54) **VERFAHREN ZUR ERZEUGUNG EINER ELEKTRISCHEN FUNKTIONSSCHICHT AUF EINER OBERFLÄCHE EINES SUBSTRATS**
METHOD FOR PRODUCING AN ELECTRIC FUNCTIONAL LAYER ON A SURFACE OF A SUBSTRATE
PROCEDE DE GENERATION D'UNE COUCHE FONCTIONNELLE ELECTRIQUE SUR UNE SURFACE D'UN SUBSTRAT

(30) Priorität: 10.08.2006 DE 102006037532
(43) Veröffentlichungstag der Anmeldung: 22.04.2009
(73) Patentinhaber: Siemens Aktiengesellschaft, 80333 München (DE)
(72) Erfinder: WEIDNER, Karl, 81245 München (DE); WEINKE, Robert, 81825 München (DE); HOLST, Jens-Christian, 14057 Berlin (DE); JENSEN, Jens Dahl, 14050 Berlin (DE)
(86) Internationale Anmeldenummer: PCT/EP2007/057883
(87) Internationale Veröffentlichungsnummer: WO 2008/017619

(56) Entgegenhaltungen:
- EP-A- 0 768 708
- DE-A1-102004 018 475
- DE-A1-102004 047 357
- LEE ET AL: "Correlation between Al2O3 particles and interface of Al-Al2O3 coatings by cold spray" APPLIED SURFACE SCIENCE, ELSEVIER, AMSTERDAM, NL, Bd. 252, Nr. 5, 15. Dezember 2005 (2005-12-15), Seiten 1891-1898, XP005175524 ISSN: 0169-4332
- KLINKOV ET AL: "Cold spray deposition: Significance of particle impact phenomena" AEROSPACE SCIENCE AND TECHNOLOGY, EDITIONS SCIENTIFIQUES ET MEDICALES ELSEVIER, Bd. 9, Nr. 7, Oktober 2005 (2005-10), Seiten 582-591, XP005107746 ISSN: 1270-9638

## Beschreibung

Die Erfindung betrifft ein Verfahren zur Erzeugung einer elektrischen Funktionsschicht auf einer Oberfläche eines Substrats, auf dem zumindest ein Bauelement, insbesondere ein Halbleiterchip, angeordnet ist.

Aus DE 10 2004 047 357 A1 ist eine elektrische Anordnung offenbart, die ein Substrat mit mindestens einem elektrischen Bauteil und/oder einer Leiterbahn umfasst, auf dem mindestens eine Metallisierung aufgebracht ist. Als Leiterbahn oder als elektrische Verbindung zweier Leiter ist mindestens eine kaltgasgespritzte Metallisierung vorgesehen.

Aus DE 10 2004 018475 A1 ist eine Leistungshalbleiteranordnung mit einem entwärmenden Grundkörper aus metallischem Material bekannt, auf den ein Leistungshalbleiterbauteil angeordnet ist. Die Außenseite des Grundkörpers weist zumindest teilweise eine elektrisch isolierende Oxidschicht auf. Eine Folie mit Aussparungen für das Leistungshalbleiterbauteil ist auf die Leistungshalbleiteranordnung auflaminiert. Auf die Folie und deren Aussparungen ist eine Metallisierung mit Metallspritztechnik aufgebracht.

Aus EP 0 768 708 A2 ist ein Verfahren zum Erzeugen von Erhebungen ("Bumps") auf einem Substrat bekannt, bei dem über das Substrat eine Maske mit Öffnungen angeordnet wird. Ein Plasma wird erzeugt. Ein Material zum Formen der Erhebungen wird in das Plasma eingeführt und durch das Plasma in geschmolzene Tropfen umgewandelt, die auf die Maske aufgebracht werden.

In der Veröffentlichung "Cold spray deposition: Significance of particle impact phenomena" von S. V. Klinkov, V. F. Kosarev, M. Rein in Aerospace Science and Technology, Editions Scientifiques et Medicales Elsevier, Bd. 9, Nr. 7, Oktober 2005, Seiten 582-591 ist das Kaltgasspritzen als Beschichtungsverfahren beschrieben.

Ausgangspunkt bei der Herstellung eines elektronischen Moduls ist ein Halbzeug mit einem Substrat, auf dem eine strukturierte Metallschicht mit Metall- oder Kontaktflächen aufgebracht ist. Auf manchen der Kontaktflächen sind jeweils ein oder mehrere Bauelemente, zum Beispiel ein Halbleiterchip oder ein passives Bauelement, aufgebracht. Das oder die Bauelemente sind über ein Verbindungsmittel, in der Regel ein Lot, mit der jeweiligen Kontaktfläche verbunden. Sofern eines der Bauelemente einen Rückseitenkontakt, das heißt einen dem Substrat zugewandten Kontakt aufweist, so wird durch das Verbindungsmittel nicht nur eine mechanische, sondern auch eine elektrische Verbindung zu der jeweiligen Kontaktfläche hergestellt.

Zur elektrischen Kontaktierung weisen manche der Bauelemente jeweils eine Anzahl an Kontaktflächen auf ihrer von dem Substrat abgewandten Oberseite auf. Die elektrische Verbindung zwischen den Kontaktflächen untereinander und/oder eine der Kontaktflächen der Metallschicht geschieht üblicherweise unter Verwendung von Bonddrähten.

Alternativ ist die Herstellung von elektrischen Verbindungen zwischen den Kontaktflächen der Bauelemente und/oder einer Kontaktfläche der Metallschicht durch eine so genannte planare Verbindungstechnologie möglich, bei der eine Oberfläche des Halbzeugs zunächst mit einer Isolationsschicht, zum Beispiel einer Kunststofffolie aus einem isolierenden Material, bedeckt wird. An den Stellen der Kontaktflächen werden Öff-nungen in die Isolationsschicht eingebracht, um die Kontaktflächen freizulegen. Anschließend wird eine dünne Metallschicht durch Sputtern, Aufdampfen und andere Verfahren zur Erzeugung dünner Kontaktschichten ganzflächig auf die Isolationsschicht und deren eingebrachte Öffnungen aufgebracht. Die Sputterschicht besteht zum Beispiel aus einer ca. 50 nm dicken Titan-Schicht und einer ca. 1 µm dicken Kupferschicht. Auf diese Sputterschicht wird eine weitere, in der Regel aus einem isolierenden Material bestehende lichtempfindliche Folie (so genannte Fotofolie) aufgebracht. Die Dicke der Fotofolie beträgt zwischen 20 und 200 µm und wird in einem weiteren Schritt entsprechend der gewünschten leitenden Struktur belichtet und entwickelt.

Die Belichtung erfolgt üblicherweise mittels einer Maske, mit der das Layout der leitenden Struktur auf die Fotofolie übertragen wird. Dabei werden diejenigen Abschnitte der Fotofolie durch die Maske abgeschattet, welche die spätere elektrisch leitende Struktur oder Funktionsschicht ausbilden sollen. Die nicht belichteten Abschnitte der Fotofolie lassen sich in einem weiteren Verfahrensschritt entfernen, so dass eine Freilegung der darunter befindlichen Sputterschicht, genauer der Kupferoberfläche, erfolgt. Durch Eintauchen des vorbereiteten Halbzeugs in ein Elektrolytbad, insbesondere ein Kupfer-Elektrolytbad, wird durch galvanische Verstärkung eine ca. 20 bis 200 µm dicke Kupferschicht aufgewachsen. In einem sich daran anschließenden Schritt, der als Strippen der Fotofolie bezeichnet wird, wird die noch auf der Oberfläche befindliche Fotofolie an den Bereichen, an welchen keine elektrisch leitende Struktur ausgebildet werden soll, entfernt. Als letzter Schritt erfolgt ein so genanntes Differenzätzen, bei dem ganzflächig die aus Titan und Kupfer bestehende Sputterschicht entfernt wird, so dass lediglich die gewünschte leitfähige Struktur beziehungsweise Funktionsschicht überbleibt.

Sind die Bauelemente als Leistungshalbleiterbauelemente ausgebildet, so wird die leitfähige Struktur beziehungsweise Funktionsschicht üblicherweise aus Kupfer ausgebildet. Die erforderliche Schichtdicke liegt im Bereich von 20 bis 500 *µ*m.

Die planare Verbindungstechnologie weist den Vorteil auf, dass die Höhe eines fertig gestellten elektronischen Moduls im Vergleich zu elektronischen Modulen mit herkömmlichen Drähten wesentlich geringer ist. Auf Grund der Vielzahl an erforderlichen Verfahrensschritten ist diese Verbindungstechnologie jedoch mit erhöhten Kosten verbunden.

Es ist daher Aufgabe der vorliegenden Erfindung, ein Verfahren zur Erzeugung einer elektrischen Funktionsschicht auf einer Oberfläche eines Substrats anzugeben, welches eine zuverlässige elektrische Kontaktierung ermöglicht und gleichzeitig kostengünstig einzusetzen ist.

Diese Aufgabe wird durch die Merkmale des unabhängigen Patentanspruchs gelöst. Vorteilhafte Ausführungsformen ergeben sich aus den abhängigen Patentansprüchen.

Bei einem erfindungsgemäßen Verfahren zur Erzeugung einer elektrischen Funktionsschicht auf einer Oberfläche eines Substrats, auf dem zumindest ein elektronisches Bauelement, insbesondere ein Halbleiterchip, aufgebracht ist, wird die elektrische Funktionsschicht dadurch gebildet, dass in Pulverform vorliegende Partikel aus einem elektrisch leitfähigen Material selektiv auf die Oberfläche des Substrats geblasen werden, so dass diese beim Aufprall auf das Substrat eine dichte und fest haftende Schicht bilden. Weiterhin wird vor dem Aufbringen der elektrischen Funktionsschicht eine Opferschicht auf die Oberfläche des Substrats aufgebracht. Erfindungsgemäß ist die Opferschicht eine Metallschicht, wobei die Dicke zur Aufnahme der kinetischen Energie der Partikel ausreicht und die Opferschicht unmittelbar auf freigelegten Kontaktflächen des elektronischen Bauelements aufgebracht wird.

Das erfindungsgemäße Verfahren weist den Vorteil auf, dass eine elektrische Verbindung kostengünstig und schnell planar hergestellt werden kann. Hierdurch ergibt sich bei einem mit dem erfindungsgemäßen Verfahren hergestellten elektronischen Moduls eine nur geringe Bauhöhe. Im Vergleich zum thermischen Flammspritzen lassen sich hochdichte Schichten erzeugen. Die Funktionsschicht weist eine hohe elektrische sowie eine hohe thermische Leitfähigkeit auf. Die Funktionsschicht ist verschleißarm und von hoher Härte, wobei während der Fertigung ein nur geringer Wärmeeintrag in das Substrat erfolgt. Auf Grund sehr hoher möglicher Auftragsraten im Bereich von mehr als 100 µm pro Minute lassen sich die Prozesszeiten bei der Herstellung von elektrischen Funktionsschichten in den Bereich von Minuten reduzieren. Weiterhin verhindert die Opferschicht eine Beschädigung der auf dem Substrat befindlichen Bauelemente durch die mit hoher kinetischer Energie aufprallenden Partikel.

Zum Aufbringen der in Pulverform vorliegenden Partikel werden die Partikel in ein aufgeheiztes und auf Überschallgeschwindigkeit, bevorzugt auf einen Geschwindigkeitsbereich zwischen 300 bis 1.200 m/s, beschleunigtes Prozessgas injiziert. Die Beschleunigung des Prozessgases auf Überschallgeschwindigkeit erfolgt bevorzugt durch eine Expansion des Prozessgases in einer Düse.

Die dem Prozessgas zugeführten Partikel sind bevorzugt aus Metall, insbesondere aus Kupfer, Titan, Silber, Nickel und Mischungen davon ausgebildet. Dabei ist es besonders bevorzugt, wenn die Partikel dem Prozessgas als Nanopartikel zugeführt werden.

Die Erzeugung der elektrischen Funktionsschicht erfolgt nach dem Prinzip des Kaltgasspritzens. Das Kaltgasspritzen ist ein Beschichtungsverfahren, bei dem der Beschichtungswerkstoff in Pulverform mit sehr hoher Geschwindigkeit auf das Substrat aufgebracht wird. Dazu wird ein auf wenige 100°C aufgeheiztes Prozessgas durch Expansion in einer Lavaldüse auf Überschallgeschwindigkeit beschleunigt. Anschließend werden die Pulverpartikel in den Gasstrahl injiziert. Die injizierten Partikel werden dabei auf eine so hohe Geschwindigkeit beschleunigt, dass sie ohne vorangehendes An- oder Aufschmelzen beim Aufprall auf das Substrat eine dichte und fest haftende Schicht bilden. Die kinetische Energie zum Zeitpunkt des Aufpralls reicht für ein vollständiges Aufschmelzen der Partikel dabei in der Regel nicht aus.

Gemäß einer Ausführungsform wird die elektrische Funktionsschicht vollflächig auf die Oberfläche des Substrats aufgebracht. Hierdurch können vollflächige oder auch nur partielle Abschirmungen zur Verbesserung des EMC-Verhaltens erzeugt werden.

Die elektrische Funktionsschicht kann auch selektiv auf die Oberfläche des Substrats aufgebracht werden zur Ausbildung einer Leiterzugstruktur.

Zur lokalen Verbesserung der Wärmeabfuhr kann weiterhin vorgesehen sein, bei der Herstellung der elektrischen Funktionsschicht Abschnitte unterschiedlicher Dicke zu erzeugen. Die Wärmeabfuhr ist dabei umso besser, je dicker die leitende Schicht ist.

Das erfindungsgemäße Verfahren erlaubt es, bei der Herstellung der elektrischen Funktionsschicht passive Bauelemente auf der Substratoberfläche auszubilden. Dies könnten beispielsweise Widerstände in Mäander-Struktur oder Kapazitäten (Ladungsspeicher) sein. Denkbar ist weiterhin, dreidimensionale Strukturen mit einer unterschiedlichen Bauteil-Topographie zu erzeugen.

Die Funktionsschicht kann aus einer Anzahl an Schichten aus unterschiedlichen oder aus gleichen Materialien gebildet werden.

Prinzipiell sind beliebige Schichtdicken in der elektrischen Funktionsschicht realisierbar. Bevorzugt beträgt die Dicke der Funktionsschicht zwischen 20 µm und 5 mm.

Erfindungsgemäß wird vor dem Aufbringen der elektrischen Funktionsschicht eine Opferschicht auf die Oberfläche des Substrats aufgebracht. Die Opferschicht verhindert eine Beschädigung der auf dem Substrat befindlichen Bauelemente durch die mit hoher kinetischer Energie aufprallenden Partikel.

Zur Erzeugung der Opferschicht wird eine dünne Metallschicht durch Sputtern, Aufdampfen oder PVB-Prozesse zur Erzeugung dünner Kontaktschichten erzeugt. Sofern die Dicke der Sputterschicht (üblicherweise im Bereich von 1 µm) zur Aufnahme der kinetischen Energie nicht ausreicht, kann vorgesehen sein, die Sputterschicht durch galvanische Abscheidung zu verstärken. Zweckmäßigerweise weist die dann erzeugte Opferschicht eine Dicke von 1 µm bis 50 µm auf.

Das Aufbringen der Partikel auf die Oberfläche des Substrats erfolgt bevorzugt unter Verwendung einer strukturierten Maske. Als Material für die Maske kann ein hoch elastisches Material verwendet werden, welches beim Anschlag die kinetische Energie der Partikel aufnimmt. Alternativ kann als Material für die Maske ein weiches Material verwendet werden, welches beim Anschlag der Partikel die Form ändert. Als Material für die Maske kann beispielsweise ein Polymer verwendet werden, der zu einer schlechten Haftung der Partikel an der Maske führt. Als Material für die Maske ist ferner ein poröses oder sprödes Material einsetzbar, welches beim Kaltgasspritzen abbricht. Solche Materialien werden beispielsweise durch Keramikpasten ausgebildet. Als Maske kann auch eine vorgeformte Metallmaske mit einer Oberflächenbeschichtung verwendet werden, wobei die Oberflächenbeschichtung ein Haften der Partikel an der Oberfläche verhindert. Die Oberflächenbeschichtung bildet eine "Antihaft-Beschichtung" aus. Schließlich kann als Maske eine strukturierte Fotofolie mit einer Oberfläche aus Silikon verwendet werden.

Zweckmäßigerweise wird die Oberfläche des Substrats mit dem zumindest einen Bauelement mit einer Isolationsschicht versehen, auf welche die elektrische Funktionsschicht aufgebracht wird. Die Isolationsschicht wird in einer Ausführungsform aus organischen oder anorganischen Isoliermaterialien gebildet, insbesondere aus einem Kunststoff, aus Glas oder aus Keramik.

Ein erfindungsgemäßes elektronisches Modul umfasst ein Substrat, auf dem zumindest ein elektronisches Bauelement, insbesondere ein Halbleiterchip, aufgebracht ist, und eine elektrisch leitende Funktionsschicht. Die elektrisch leitende Funktionsschicht ist nach dem beschriebenen Verfahren ausgebildet.

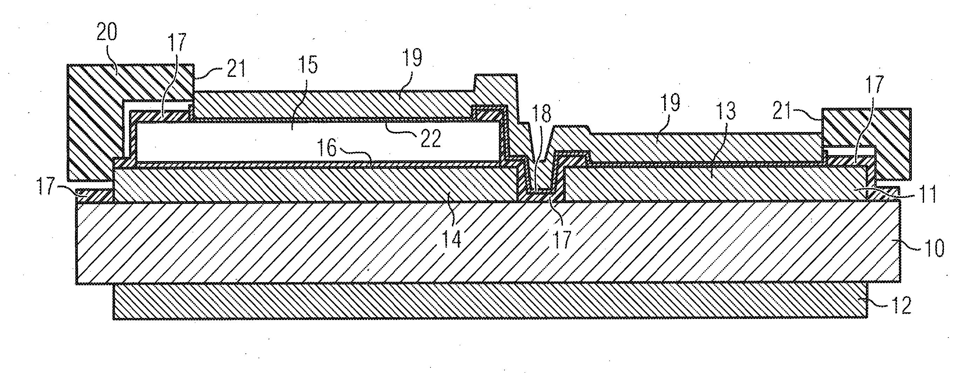

Die Erfindung wird nachfolgend anhand eines Ausführungsbeispiels in der Zeichnung näher erläutert.

Die einzige Figur zeigt in einer schematischen Darstellung einen Schnitt durch ein gemäß dem erfindungsgemäßen Verfahren hergestelltes elektronisches Modul.

Auf einer Oberseite eines Substrats 10 ist eine Metallschicht 11, zum Beispiel aus Kupfer, ausgebildet. Das Substrat 10 kann beispielsweise aus einer Keramik, einem Leiterplattenmaterial (PCB - Printed Circuit Board) oder einem flexiblen Tape gebildet sein. Die Metallschicht 11 weist eine Anzahl an Kontaktflächen 13, 14 auf, wobei im Ausführungsbeispiel lediglich zwei Kontaktflächen dargestellt sind. Auf einer der Oberseite gegenüberliegenden Unterseite des Substrats 10 ist ebenfalls eine Metallschicht 12 ausgebildet, auf welcher beispielsweise ein Kühlkörper angeordnet werden kann. Die Metallschicht 12 ist zu diesem Zweck beispielhaft ganzflächig ausgebildet und ebenfalls aus Kupfer gebildet.

Auf der Kontaktfläche 14 ist über ein Haftmittel 16, zum Beispiel eine Lotpaste, ein Bauelement 15, zum Beispiel ein Leistungshalbleiterbauelement, aufgebracht, das auf seiner von dem Substrat abgewandten Oberseite beispielhaft eine Kontaktfläche 22 aufweist. Die Oberfläche der beschriebenen Anordnung (nachfolgend auch als Halbzeug bezeichnet) ist mit einer Isolierschicht 17 versehen. Die Isolierschicht 17 kann durch einen Vakuumprozess aufgebracht worden sein. Die Dicke der Isolierschicht 17 richtet sich nach der Anwendung des fertig gestellten elektronischen Moduls, insbesondere nach den im Betrieb des Moduls auftretenden Spannungen. Typischerweise beträgt die Dicke der Isolierschicht 17 ein 100 bis 400 µm. Das Aufbringen der Isolierschicht 17 erfolgt derart, dass zwischen der Isolierschicht 17 und der Oberfläche des Halbzeugs, umfassend das metallisierte Substrat mit dem darauf aufgebrachten Bauelement, keine Lufteinschlüsse bestehen, welche die Gefahr von Spannungsüberschlägen begünstigen. Beim Aufbringen der Isolierschicht 17 kommt bevorzugt ein Verfahren zur Anwendung, welches die Isolierschicht 17 an den Seitenkanten des Bauelements nicht oder nur wenig streckt oder staucht. Die Isolierschicht 10 weist deshalb bevorzugt über die gesamte Oberfläche des Halbzeugs eine konstante Dicke auf, wodurch die elektrischen Eigenschaften des fertig gestellten elektronischen Moduls optimiert sind. In die Isolierschicht 17 sind im Bereich der Kontaktflächen 13 und 22 Öffnungen eingebracht. Das Einbringen der Öffnungen wird üblicherweise mittels eines Lasers durchgeführt.

Nach dem Aufbringen der Isolierschicht 17 und dem Einbringen der Öffnungen wird die mit einer elektrischen Funktionsschicht zu bedeckende Oberfläche des Halbzeugs mit einer Maske 20 versehen. Die Maske 20 kann, wie im Ausführungsbeispiel dargestellt, unmittelbar auf die mit einer Funktionsschicht zu versehende Oberfläche des Halbzeugs aufgebracht werden. Die Maske kann jedoch auch beabstandet zu der Oberfläche angeordnet werden, um die gewünschte Abschattung zu bewirken.

Im Ausführungsbeispiel weist die Maske lediglich beispielhaft eine einzige, große Öffnung 21 auf, innerhalb welcher die Kontaktfläche 22 des Bauelements 15 und die Kontaktfläche 13 der Metallschicht 11 freigelegt sind. Prinzipiell ist die Maske derart ausgestaltet, dass Bereiche, welche nicht mit einer elektrischen Funktionsschicht belegt werden sollen, durch die Maske abgeschattet oder verdeckt werden.

Im Bereich der Öffnung 21 der Maske 20 ist auf die Oberfläche des Halbzeugs eine Opferschicht 18 aufgebracht. Das Aufbringen der Opferschicht 18 ist im Ausführungsbeispiel nach dem Aufbringen der Maske 20 erfolgt, was jedoch nicht zwingend ist. Die Opferschicht 18 ist aus einem leitenden Material gebildet und ist unmittelbar auf den freigelegten Kontaktflächen 13 und 22 aufgebracht, wo wie Isolierschicht 17 Öffnungen aufweist. Im Übrigen verläuft die Opferschicht 18 auf der Isolierschicht 17. Die Opferschicht 18 passt sich damit der dreidimensionalen Oberflächenstruktur des Halbzeugs an.

Die Opferschicht 18 kann durch Sputtern erzeugt sein. Gegebenenfalls kann die Sputterschicht durch eine galvanische Abscheidung verstärkt sein, wobei die Opferschicht bevorzugt eine Dicke von 1 bis 10 µm aufweist. Durch die Opferschicht 18 ist sichergestellt, dass insbesondere das Bauelement 15 beim noch folgenden Aufbringen der elektrisch leitenden Partikel mit hoher kinetischer Energie nicht beschädigt wird.

Das Aufbringen der in Pulverform vorliegenden Partikel, zum Beispiel aus Kupfer, Titan, Silber, Nickel oder Mischungen davon, bevorzugt in Form von Nanopartikeln, erfolgt durch Aufblasen auf die mit der Maske 20 versehene Oberfläche des Halbzeugs. Hierzu werden die Partikel in ein aufgeheiztes und auf Überschallgeschwindigkeit beschleunigtes Prozessgas injiziert. Die Beschleunigung des Prozessgases erfolgt zum Beispiel durch eine Expansion mittels einer Düse. Das Prozessgas weist bevorzugt eine Geschwindigkeit zwischen 300 und 1.200 m/s auf. Als Trägergase kommen im Wesentlichen inerte Gase, insbesondere Stickstoff, in Betracht. Das Verfahren zum Aufbringen der in Pulverform vorliegenden Partikel ist auch unter dem Begriff des Kaltgasspritzens bekannt.

Es können die so genannte gradiente Materialien aufgebracht werden, die als Kontaktflächen ein Metall aufweisen sowie eine Barriereschicht über Titan.

Über die Zeitdauer des Aufblasens der Partikel auf die Oberfläche des Halbzeugs wird die Dicke der elektrischen Funktionsschicht 19 bestimmt. Pro Minute lassen sich dabei Dicken von mehr als 100 µm erreichen.

Das Aufbringen der elektrischen Funktionsschicht 19 kann in mehreren Schritten erfolgen, um einen geschichteten Aufbau der Funktionsschicht zu erhalten. Ein derartiger Aufbau ist vorteilhaft zur Vermeidung von Kupfer-Migration. Ein weiterer Vorteil besteht darin, dass eine Strukturierung mittels eines Lasers möglich ist.

Nach der Erzeugung der elektrischen Funktionsschicht 19 kann die Maske 20 von der Oberfläche des erzeugten elektronischen Moduls entfernt werden.

Als geeignete Materialien für die Maske können hoch elastische Materialien, weiche Materialien, poröse oder spröde Materialien eingesetzt werden. Es ist ferner die Verwendung einer vorgeformten Metallmaske mit einer Oberflächenbeschichtung, an der Metall nicht haftet, oder eine strukturierte Fotofolie mit einer Silikonoberfläche denkbar.

Als hoch elastisches Material für eine Maske kann zum Beispiel ein Silikongummi verwendet werden. Dieser nimmt beim Anschlag der Partikel auf die Maske die kinetische Energie von den Partikeln auf. Weiche Masken-Materialien ändern beim Aufbringen der Partikel ihre Form und führen dadurch zu einer schlechten Haftung zwischen der Maske und den Partikeln. Dadurch kann das nicht auf die Oberfläche des Halbzeugs gelangende Material wieder verwendet werden. Poröse oder spröde Materialien, zum Beispiel Keramikpasten, brechen beim Kaltgasspritzen ab und nehmen dabei die Energie der Partikel auf.

In einer weiteren, in der Figur nicht dargestellten Ausführungsform kann auf die Funktionsschicht 19, zum Beispiel ausschließlich im Bereich des Bauelements 15 eine oder mehrere weitere Metallschichten zur Verbesserung der thermischen Eigenschaften aufgebracht sein. Auf dieser wiederum kann isolierende Schicht beziehungsweise ein Kühlelement oder - schicht aufgebracht sein.

Mit dem erfindungsgemäßen Verfahren ist die Herstellung von elektronischen Modulen mit Mehrschicht- oder Stackaufbauten möglich, bei denen abwechselnd Isolierschichten und elektrische Funktionsschichten übereinander angeordnet sind.

Ein mit dem erfindungsgemäßen Verfahren hergestelltes elektronisches Modul weist den Vorteil auf, dass die elektrischen Verbindungen in einer planaren Ebene realisiert sind, so dass das Bauteil eine nur geringe Höhe aufweist. Insbesondere lassen sich durch das erfindungsgemäße Verfahren nicht nur Leiterzugstrukturen herstellen, sondern es können auch flächige Bereiche mit einer elektrisch leitenden Schicht versehen werden. Hierdurch kann das EMC-Verhalten des elektronischen Moduls verbessert werden.

## Patentansprüche

1. Verfahren zur Erzeugung einer elektrischen Funktionsschicht (19) auf einer Oberfläche eines Substrats (10), auf dem zumindest ein elektronisches Bauelement (15), insbesondere ein Halbleiterchip, aufgebracht ist, wobei die elektrische Funktionsschicht (19) dadurch gebildet wird, dass in Pulverform vorliegende Partikel aus einem elektrisch leitfähigen Material selektiv auf die Oberfläche des Substrats (10) geblasen werden, so dass diese beim Aufprall auf das Substrat (10) eine dichte und fest haftende Schicht bilden und dass vor dem Aufbringen der elektrischen Funktionsschicht (19) eine Opferschicht (18) auf die Oberfläche des Substrats (10) und auf das elektronische Bauelement (15) aufgebracht wird
**dadurch gekennzeichnet, dass**
die Opferschicht (18) eine Metallschicht ist, wobei die Dicke zur Aufnahme der kinetischen Energie der Partikel ausreicht und die Opferschicht (18) unmittelbar auf freigelegten Kontaktflächen des elektronischen Bauelements (15) aufgebracht wird.

2. Verfahren nach Anspruch 1,
**dadurch gekennzeichnet, dass**
die Partikel in ein aufgeheiztes und auf Überschallgeschwindigkeit, bevorzugt auf einen Geschwindigkeitsbereich zwischen 300 und 1200m/s, beschleunigtes Prozessgas injiziert werden.

3. verfahren nach Anspruch 2,
**dadurch gekennzeichnet, dass**
die dem Prozessgas zugeführten Partikel aus Metall, insbesondere aus Kupfer, Titan, Silber, Nickel und Mischungen davon ausgebildet sind.

4. Verfahren nach Anspruch 2 oder 3,
**dadurch gekennzeichnet, dass**
die Partikel dem Prozessgas als Nanopartikel zugeführt werden.

5. Verfahren nach einem der vorherigen Ansprüche,
**dadurch gekennzeichnet, dass**
das Prozessgas durch Expansion auf Überschallgeschwindigkeit beschleunigt wird.

6. Verfahren nach einem der vorherigen Ansprüche,
**dadurch gekennzeichnet, dass**
die elektrische Funktionsschicht (19) vollflächig auf die Oberfläche des Substrats (10) aufgebracht wird.

7. Verfahren nach einem der vorherigen Ansprüche,
**dadurch gekennzeichnet, dass**
die elektrische Funktionsschicht (19) selektiv auf die Oberfläche des Substrats (10) aufgebracht wird zur Ausbildung einer Leiterzugstruktur.

8. Verfahren nach einem der vorherigen Ansprüche,
**dadurch gekennzeichnet, dass**
bei der Herstellung der elektrischen Funktionsschicht (19) Abschnitte unterschiedlicher Dicke erzeugt werden.

9. Verfahren nach einem der vorherigen Ansprüche,
**dadurch gekennzeichnet, dass**
bei der Herstellung der elektrischen Funktionsschicht (19) passive Bauelemente auf der Substratoberfläche ausgebildet werden.

10. Verfahren nach einem der vorherigen Ansprüche,
**dadurch gekennzeichnet, dass**
die Funktionsschicht (19) aus einer Anzahl an Schichten aus unterschiedlichen oder gleichen Materialien gebildet wird.

11. Verfahren nach einem der vorherigen Ansprüche,
**dadurch gekennzeichnet, dass**
die Dicke der Funktionsschicht (19) zwischen 20 *µ*m und 5 mm beträgt.

12. Verfahren nach Anspruch 11,
**dadurch gekennzeichnet, dass**
zur Erzeugung der Opferschicht (18) eine dünne Metallschicht durch Sputtern, Aufdampfen oder PVB-Prozesse zur Erzeugung dünner Kontaktschichten erzeugt wird.

13. Verfahren nach Anspruch 10,
**dadurch gekennzeichnet, dass**
die Sputterschicht durch galvanische Abscheidung verstärkt wird.

14. Verfahren nach einem der Ansprüche 11 bis 13,
**dadurch gekennzeichnet, dass**
die Opferschicht (18) in einer Dicke von 1 *µ*m bis 10 *µ*m erzeugt wird.

15. Verfahren nach einem der vorherigen Ansprüche,
**dadurch gekennzeichnet, dass**
das Aufbringen der Partikel auf die Oberfläche des Substrats (10) unter Verwendung einer strukturierten Maske (20) erfolgt.

16. Verfahren nach einem der vorherigen Ansprüche,
**dadurch gekennzeichnet, dass**
als Material für die Maske (20) ein hoch elastisches Material verwendet wird, welches beim Anschlag die kinetische Energie der Partikel aufnimmt.

17. Verfahren nach Anspruch 16,
**dadurch gekennzeichnet, dass**
als Material für die Maske (20) ein weiches Material verwendet wird, welches beim Anschlag der Partikel die Form ändert.

18. Verfahren nach Anspruch 16,
**dadurch gekennzeichnet, dass**
als Material für die Maske (20) ein poröses oder sprödes Material verwendet wird.

19. Verfahren nach Anspruch 16,
**dadurch gekennzeichnet, dass**
als Maske (20) eine vorgeformte Metallmaske mit einer Oberflächenbeschichtung verwendet wird, wobei die Oberflächenbeschichtung ein Haften der Partikel an der Oberfläche verhindert.

20. Verfahren nach Anspruch 16,
**dadurch gekennzeichnet, dass**
als Maske (20) eine strukturierte Fotofolie mit einer Oberfläche aus Silikon verwendet wird.

21. Verfahren nach einem der vorherigen Ansprüche,
**dadurch gekennzeichnet, dass**
die Oberfläche des Substrats (10) mit dem zumindest einen Bauelement (15) mit einer Isolationsschicht (17) versehen wird, auf welche die elektrische Funktionsschicht (19) aufgebracht wird.

22. Verfahren nach Anspruch 21,
**dadurch gekennzeichnet, dass**
die Isolationsschicht (17) aus organischen oder anorganischen Isoliermaterialien gebildet wird, insbesondere aus einem Kunststoff, aus Glas oder aus Keramik gebildet wird.

## Claims

1. Method to produce an electric functional layer (19) on a surface of a substrate (10), on which at least one electronic component (15), in particular a semiconductor chip, is applied, whereby the electric functional layer (19) is formed by blowing powder particles made of an electrically conductive material selectively onto the surface of the substrate (10) so that they form a dense and strongly adhering layer on impact with the substrate (10) and, before application of the electric functional layer (19), a sacrificial layer (18) is applied to the surface of the substrate (10) and to the electronic component (15),
**characterised in that**
the sacrificial layer (18) is a metal layer, whereby the thickness is enough to absorb the kinetic energy of the particles and the sacrificial layer (18) is applied directly to the exposed contact surfaces of the electronic component (15).

2. Method according to claim 1,
**characterised in that**
the particles are injected into a process gas which has been heated up and accelerated to supersonic speed, preferably to a speed of between 300 and 1200 m/s.

3. Method according to claim 2,
**characterised in that**
the particles injected into the process gas are made of metal, in particular of copper, titanium, silver, nickel and mixtures thereof.

4. Method according to claim 2 or 3,
**characterised in that**
the particles are injected into the process gas as nanoparticles.

5. Method according to one of the above claims,
**characterised in that**
the process gas is accelerated by expansion to supersonic speed.

6. Method according to one of the above claims,
**characterised in that**
the electric functional layer (19) is applied over the full surface of the substrate (10).

7. Method according to one of the above claims,
**characterised in that**
the electric functional layer (19) is applied selectively to the surface of the substrate (10) in order to form a conductor path structure.

8. Method according to one of the above claims,
**characterised in that**
in the production of the electric functional layer (19) sections of different thickness are formed.

9. Method according to one of the above claims,
**characterised in that**
in the production of the electric functional layer (19) passive elements are formed on the substrate surface.

10. Method according to one of the above claims,
**characterised in that**
the functional layer (19) is formed from a number of layers of different or the same materials.

11. Method according to one of the above claims,
**characterised in that**
the thickness of the functional layer (19) is between 20 µm and 5 mm.

12. Method according to claim 11,
**characterised in that**
to produce the sacrificial layer (18) a thin metal layer is produced by sputtering, vapor deposition or PVD processes to produce thin contact layers.

13. Method according to claim 10,
**characterised in that**
the sputter layer is thickened by galvanic deposition.

14. Method according to one of the claims 11 to 13, **characterised in that**
the sacrificial layer (18) is produced in a thickness of 1 µm to 10 µm.

15. Method according to one of the above claims,
**characterised in that**
the particles are applied to the surface of the substrate (10) using a structured mask (20).

16. Method according to one of the above claims,
**characterised in that**
the material used for the mask (20) is a highly elastic material which absorbs the kinetic energy of the particles on impact.

17. Method according to claim 16,
**characterised in that**
the material used for the mask (20) is a soft material which changes shape on impact of the particles.

18. Method according to claim 16,
**characterised in that**
the material used for the mask (20) is a porous or brittle material.

19. Method according to claim 16,
**characterised in that**
for the mask (20) a preformed metal mask with a surface coating is used, whereby the surface coating prevents adhesion of the particles on the surface.

20. Method according to claim 16,
**characterised in that**
for the mask (20) a structured photo foil with a surface made of silicone is used.

21. Method according to one of the above claims,
**characterised in that**
the surface of the substrate (10) having at least one component (15) is provided with an insulation layer (17) onto which the electric functional layer (19) is applied.

22. Method according to claim 21,
**characterised in that**
the insulation layer (17) is formed from organic or inorganic insulation materials, in particular plastic, glass or ceramic.

## Revendications

1. Procédé de génération d'une couche fonctionnelle électrique (19) sur une surface d'un substrat (10) sur lequel est déposé au moins un composant électronique (15), en particulier une puce de semi-conducteur, la couche fonctionnelle électrique (19) étant formée par soufflage sélectif sur la surface du substrat (10) de particules sous forme de poudre d'un matériau électriquement conducteur, de sorte que celles-ci, lors de leur impact sur le substrat (10), forment une couche dense et fortement adhérente, et par le fait que, avant l'application de la couche fonctionnelle électrique (19), une couche sacrificielle (18) est appliquée sur la surface du substrat (10) et sur le composant électronique (15),
**caractérisé en ce que**
la couche sacrificielle (18) est une couche métallique dont l'épaisseur est suffisante pour absorber l'énergie cinétique des particules, et la couche sacrificielle (18) est appliquée directement sur des surfaces de contact dégagées du composant électronique (15).

2. Procédé selon la revendication 1,
**caractérisé en ce que**
les particules sont injectées dans un gaz de traitement chauffé et accéléré jusqu'à la vitesse supersonique, de préférence jusqu'à une plage de vitesse comprise entre 300 et 1200 m/s.

3. Procédé selon la revendication 2,
**caractérisé en ce que**
les particules envoyées dans le gaz de traitement sont formées de métal, en particulier de cuivre, titane, argent, nickel et de mélanges de ceux-ci.

4. Procédé selon la revendication 2 ou 3,
**caractérisé en ce que**
les particules sont envoyées sous forme de nanoparticules dans le gaz de traitement.

5. Procédé selon l'une des revendications précédentes,
**caractérisé en ce que**
le gaz de traitement est accéléré par expansion jusqu'à la vitesse supersonique.

6. Procédé selon l'une des revendications précédentes,
**caractérisé en ce que**
la couche fonctionnelle électrique (19) est appliquée sur toute la surface du substrat (10).

7. Procédé selon l'une des revendications précédentes,
**caractérisé en ce que**
la couche fonctionnelle électrique (19) est appliquée sélectivement sur la surface du substrat (10) de manière à former une structure de pistes conductrices.

8. Procédé selon l'une des revendications précédentes,
**caractérisé en ce que**
lors de la réalisation de la couche fonctionnelle électrique (19), des parties d'épaisseur différente sont formées.

9. Procédé selon l'une des revendications précédentes,
**caractérisé en ce que**
lors de la réalisation de la couche fonctionnelle électrique (19), des composants passifs sont formés sur la surface de substrat.

10. Procédé selon l'une des revendications précédentes,
**caractérisé en ce que**
la couche fonctionnelle (19) est formée de plusieurs couches de matériaux différents ou identiques.

11. Procédé selon l'une des revendications précédentes,
**caractérisé en ce que**
l'épaisseur de la couche fonctionnelle (19) est comprise entre 20 µm et 5 mm.

12. Procédé selon la revendication 11,
**caractérisé en ce que**
pour réaliser la couche sacrificielle (18), on réalise une mince couche métallique par pulvérisation cathodique, dépôt en phase vapeur ou procédés PVB pour obtenir de minces couches de contact.

13. Procédé selon la revendication 10,
**caractérisé en ce que**
la couche obtenue par pulvérisation cathodique est renforcée par dépôt galvanique.

14. Procédé selon l'une des revendications 11 à 13,
**caractérisé en ce que**
la couche sacrificielle (18) est réalisée en une épaisseur de 1 µm à 10 µm.

15. Procédé selon l'une des revendications précédentes,
**caractérisé en ce que**
l'application des particules sur la surface du substrat (10) est réalisée en utilisant un masque structuré (20).

16. Procédé selon l'une des revendications précédentes,
**caractérisé en ce que**
on utilise comme matériau pour le masque (20) un matériau hautement élastique qui absorbe l'énergie cinétique des particules lors de leur impact.

17. Procédé selon la revendication 16,
**caractérisé en ce que**
on utilise comme matériau pour le masque (20) un matériau souple qui change de forme lors de l'impact des particules.

18. Procédé selon la revendication 16,
**caractérisé en ce que**
on utilise comme matériau pour le masque (20) un matériau poreux ou friable.

19. Procédé selon la revendication 16,
**caractérisé en ce que**
on utilise comme masque (20) un masque métallique préformé muni d'un revêtement de surface, le revêtement de surface empêchant les particules d'adhérer à la surface.

20. Procédé selon la revendication 16,
**caractérisé en ce que**
on utilise comme masque (20) une feuille photosensible structurée ayant une surface en silicone.

21. Procédé selon l'une des revendications précédentes,
**caractérisé en ce que**
on munit la surface du substrat (10), doté du au moins un composant (15), d'une couche d'isolation (17) sur laquelle on vient déposer la couche fonctionnelle électrique (19).

22. Procédé selon la revendication 21,
**caractérisé en ce que**
la couche d'isolation (17) est réalisée en matériaux isolants organiques ou inorganiques, en particulier en une matière plastique, en verre ou en céramique.
